# FASCICULE DE BREVET EUROPEEN

(11) **EP 3 076 769 B1**
(45) Date de publication et mention de la délivrance du brevet: **06.12.2017**
(21) Numéro de dépôt: 16163485.2
(22) Date de dépôt: 01.04.2016
(51) Int. Cl.: H05K 1/03, H05K 3/00, H05K 3/46, H05K 1/11, H05K 3/24, H05K 3/40, G06K 19/077

(54) **PROCÉDÉ DE FABRICATION D'UN CIRCUIT FLEXIBLE, CIRCUIT FLEXIBLE OBTENU PAR CE PROCÉDÉ ET CARTE À PUCE COMPORTANT UN TEL CIRCUIT FLEXIBLE**
HERSTELLUNGSVERFAHREN EINES FLEXIBLEN SCHALTKREISES, MIT DIESEM VERFAHREN HERGESTELLTER FLEXIBLER SCHALTKREIS UND CHIPKARTE, DIE EINEN SOLCHEN FLEXIBLEN SCHALTKREIS UMFASST
METHOD FOR MANUFACTURING A FLEXIBLE CIRCUIT, FLEXIBLE CIRCUIT OBTAINED BY SAID METHOD AND CHIP CARD COMPRISING SUCH A FLEXIBLE CIRCUIT

(30) Priorité: 03.04.2015 FR 1552933
(43) Date de publication de la demande: 05.10.2016
(73) Titulaire: Linxens Holding, 78280 Guyancourt (FR)
(72) Inventeur: LAURENS DE LOPEZ, Claire, 78480 Verneuil sur Seine (FR); DIEU-GOMONT, Séverine, 78270 Limetz-Villez (FR); ARZINE, Najate, 78200 Mantes la Jolie (FR)
(74) Mandataire: GIE Innovation Competence Group

(56) Documents cités:
- WO-A1-2014/147154
- KR-A- 20140 001 547
- US-A- 5 798 014

## Description

L'invention concerne le domaine des circuits imprimés flexibles. De tels circuits imprimés flexibles peuvent être utilisés par exemple pour réaliser des modules électroniques pour carte à puce, des antennes RFID, des supports de diodes électroluminescentes, etc.

L'invention est illustrée ci-dessous en prenant l'exemple des modules électroniques pour cartes à puce, mais elle est facilement transposable à d'autres applications des circuits imprimés flexibles et notamment à des applications telles que celles mentionnées ci-dessus.

Les cartes à puce sont bien connues du public, qui en a de multiples usages : cartes de crédit, carte SIM pour téléphones portable, cartes de transport, cartes d'identité, etc.

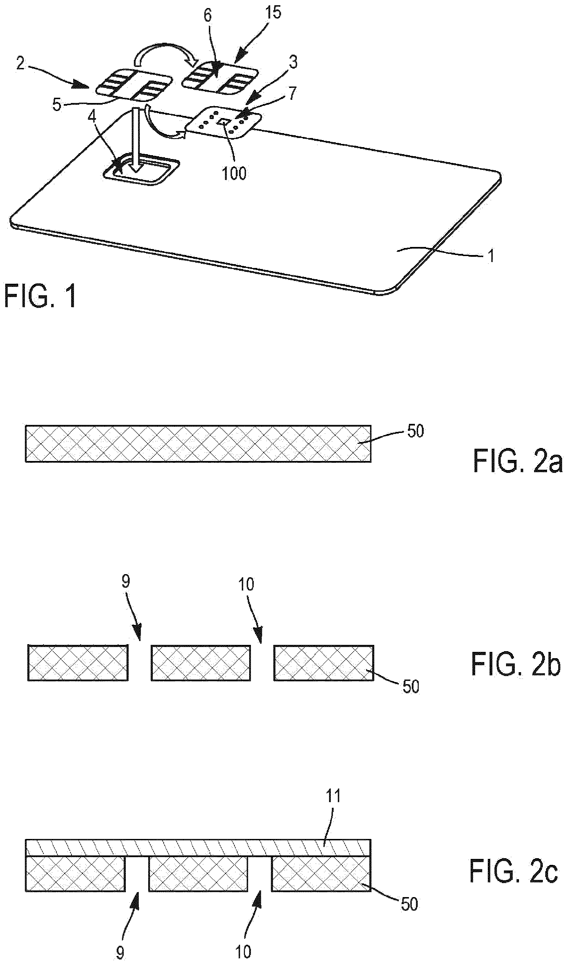

Comme représenté sur la figure 1, les cartes à puce sont généralement constituées d'un support rigide 1 en matière plastique de type PVC, PVC/ABS ou polycarbonate constituant l'essentiel de la carte, dans lequel est incorporé un module électronique 2 fabriqué séparément. Ce module électronique 2 comporte un circuit imprimé 3 généralement flexible muni d'une puce électronique 100 (circuit intégré) et de moyens de transmission pour transmettre des données de la puce à un dispositif lecteur de carte (lecture) ou de ce dispositif à la carte (écriture). Ces moyens de transmission de données peuvent être « à contact », « sans contact » ou bien « dual » lorsqu'ils combinent les deux précédents moyens. Dans une carte à puce « à contact » ou « dual », un connecteur 5 comporte des plages de contacts 15 électriquement connectées à la puce 100 et affleurant, en surface du support de carte 1, pour une connexion par contact électrique avec un dispositif lecteur de carte.

Dans l'art antérieur, les modules sont généralement formés à partir d'un substrat diélectrique recouvert sur au moins l'une de ses faces d'une feuille de matériau électriquement conducteur, constituée par exemple d'un métal tel que du cuivre, de l'acier ou de l'aluminium ou un alliage de l'un de ces métaux. Dans cette feuille de matériau électriquement conducteur sont formées des pistes conductrices formant des plages de contacts électriques. Les substrats diélectriques largement utilisés dans l'art antérieur sont réalisés en matériaux composites (verre-époxy) ou en matériaux plastiques (PET, PEN, polyimide, etc.). Ce type de substrat diélectrique est généralement mince (son épaisseur est par exemple de l'ordre de 100 µm) pour conserver une flexibilité compatible avec des procédés de fabrication des modules électroniques en continu. D'autres procédés de fabrication de modules de carte à puce de l'art antérieur sont décrits dans les demandes de brevet KR 2014 0001547 A et WO 2014/147154 A1.

Le procédé de fabrication de ce type de circuit flexible comprend alors par exemple:
- la fourniture d'une feuille de matériau électriquement conducteur, ayant donc une première et une deuxième face principales,
- la fourniture d'une couche de matériau diélectrique, cette couche de matériau diélectrique ayant donc aussi une première et une deuxième face principales, et

- la lamination de la feuille de matériau électriquement conducteur avec la couche de matériau diélectrique.

La feuille de matériau électriquement conducteur est généralement collée à la couche de matériau diélectrique au moyen d'une fine couche de matériau adhésif généralement thermodurcissable (mais qui pourrait éventuellement être thermofusible) et électriquement isolant (dont l'épaisseur est par exemple de l'ordre de 20 µm), préalablement enduite sur la couche de matériau diélectrique.

Un but de l'invention est de simplifier ce type de procédé.

A cet effet, il est prévu, un procédé tel que celui mentionné ci-dessus et défini par la revendication 1, comprenant en outre, avant la lamination de la feuille de matériau électriquement conducteur avec la couche de matériau diélectrique, une étape de perforation d'au moins un puits de connexion à travers la couche de matériau diélectrique. Après la lamination de la feuille de matériau électriquement conducteur avec la couche de matériau diélectrique, la feuille de matériau électriquement conducteur forme donc une surface de connexion au fond d'au moins un puits de connexion. De plus on utilise une couche de matériau diélectrique constituée d'un matériau pré-imprégné. Ainsi, on peut réaliser l'étape de lamination de la feuille de matériau électriquement conducteur avec la couche de matériau diélectrique, alors que la première face de la couche de matériau diélectrique est directement mise en contact avec la première face de la feuille de matériau électriquement conducteur. Autrement dit, le terme « directement mise en contact» signifie dans ce document que la feuille de matériau électriquement conducteur est laminée avec la couche de matériau diélectrique sans autre couche intermédiaire, et plus particulièrement sans couche supplémentaire d'adhésif entre les deux.

Grâce à cette disposition, il est possible d'éliminer l'étape utilisée lors de la mise en oeuvre des procédés de l'art antérieur qui consistait à enduire d'adhésif la couche de matériau diélectrique. Cette disposition rend donc ce type procédé plus économique.

Un pré-imprégné (« prepreg » selon la terminologie anglo-saxonne) dans ce document est un produit semi-fini constitué d'une résine (encore appelée matrice) thermodurcissable (c'est à dire thermo-réticulable) imprégnant un renfort (mat, tissu, fibre de verre). La résine doit être réticulée à chaud pour obtenir un produit fini.

L'étape de perforation d'au moins un puits de connexion à travers la couche de matériau diélectrique est réalisée avant celle de lamination de la couche de matériau diélectrique avec la feuille de matériau électriquement conducteur de manière à faire cette perforation par un moyen mécanique, rapide et économique tel que le poinçonnage. Les puits de connexion ayant généralement un diamètre de l'ordre de 600 à 800µm, il est important que la résine du pré-imprégné ne flue pas dans le fond des puits, sur la surface du matériau électriquement conducteur. Pour cette raison notamment, il n'était pas évident de remplacer un substrat diélectrique thermiquement stable (aux températures d'utilisation habituelle pour ce type de procédé et généralement inférieures à 300°C) de l'art antérieur par un substrat diélectrique qui n'est encore stable (par exemple parce qu'il n'est pas encore réticulé) et qui peut donc fluer de manière significative. Il faut en effet éviter que la résine du pré-imprégné ne recouvre la surface conductrice du fond du puits et compromette une bonne connexion ultérieure. Le pré-imprégné est donc choisi pour que son fluage mesuré selon le standard IPC-TM-650 2.3.17.2 reste inférieur ou égal à 0,7mm. D'une manière générale, on peut limiter le fluage de la résine en augmentant sa viscosité, par exemple par ajout de charges à cette résine ou en la pré-réticulant. Il y a cependant un compromis à trouver entre, d'une part, une résine trop peu visqueuse qui flue trop mais adhère à la feuille de matériau électriquement conducteur et, d'autre part, une résine qui ne flue pas (dite « no-flow » selon la terminologie anglo-saxonne), mais qui ne présenterait pas les propriétés d'adhérence recherchée aux températures (inférieures à 220°C) et pressions (2 à 6 bars) souhaitées pour la mise en oeuvre de ce procédé.

Le procédé ci-dessus comporte en outre éventuellement l'une ou l'autre des caractéristiques suivantes considérées indépendamment les unes des autres ou en combinaison de tout ou partie d'entre elles :
- le procédé comprend une étape de réticulation de la résine après l'étape de lamination de la feuille de matériau électriquement conducteur avec la couche de matériau diélectrique ;
- la résine est choisie dans la liste comprenant les résines époxy et les résines de polyesters insaturés;
- le renfort est choisi parmi un textile de fibres tissées, un textile de fibres non-tissées, des fibres de verre, des fibres de polyester, des fibres de carbone et des fibres de polyaramide ;
- l'étape de lamination de la feuille de matériau électriquement conducteur avec la couche de matériau diélectrique, est réalisée à une température comprise entre 80°C et 200°C et préférentiellement entre 100 et 150°C ; cette température est adaptée au mode de mise en oeuvre de l'étape de lamination, par exemple, l'étape de lamination est réalisée en continu («reel-to-reel» ou « roll-to-roll » selon la terminologie anglo-saxonne) et la couche de matériau diélectrique (pré-imprégné) est préchauffée avant d'être laminée avec la feuille de matériau électriquement conducteur sous un rouleau lui aussi chauffé ; dans ce cas, le temps de contact entre le rouleau, la feuille de matériau électriquement conducteur et la couche de matériau diélectrique est très court ;
- l'étape de lamination de la feuille de matériau électriquement conducteur avec la couche de matériau diélectrique est réalisée à une pression comprise entre 2 et 6 bars, notamment lorsque l'étape de lamination est réalisée en continu ;
- l'étape de perforation d'au moins un puits de connexion est réalisée après lamination d'une première feuille de matériau électriquement conducteur sur la première face de la couche de matériau diélectrique et une deuxième feuille de matériau électriquement conducteur est laminée sur la deuxième face de la couche de matériau diélectrique.

Selon un autre aspect, l'invention est un circuit flexible défini par la revendication 8, obtenu par le procédé ci-dessus et comprenant :
- une couche de matériau diélectrique ayant une première et une deuxième face, cette couche de matériau diélectrique étant constituée d'un matériau pré-imprégné ayant un fluage inférieur ou égal à 0,7mm mesuré selon le standard IPC-TM-650 2.3.17.2,
- une feuille de matériau électriquement conducteur, ayant une première et une deuxième face, recouvrant au moins partiellement la couche de matériau diélectrique, la première face de la couche de matériau diélectrique étant directement au contact de la première face de la feuille de matériau électriquement conducteur,
- au moins un puits de connexion à travers la couche de matériau diélectrique, la feuille de matériau électriquement conducteur formant une surface de connexion au fond d'au moins un puits de connexion.

Selon encore un autre aspect, l'invention est une carte à puce comportant un corps de carte et une cavité ménagée dans le corps de carte et dans laquelle est placé un module électronique comportant un circuit flexible tel que mentionné ci-dessus, le circuit flexible comportant une zone fixée au corps de carte, par exemple à l'aide d'un adhésif réactivable à chaud (« hotmelt » selon la terminologie anglo-saxonne).

D'autres caractéristiques et avantages de l'invention apparaîtront à la lecture de la description détaillée et des dessins annexés sur lesquels :
- La figure 1 représente schématiquement en perspective une carte à puce destinée à recevoir un circuit flexible ;
- Les figures 2a à 2i représentent schématiquement les différentes étapes d'un exemple de procédé de fabrication d'un circuit imprimé et d'encartage de ce circuit imprimé ; et
- la figure 3 représente schématiquement une variante de l'étape 2h du procédé illustré par les figures 2a à 2i.

Un exemple de procédé de fabrication d'un circuit flexible selon l'invention est décrit ci-dessous. Il appartient au domaine de la carte à puce, mais comme cela a déjà été mentionné, des applications dans d'autres domaines (antennes RFID, LEDs, etc.) sont aisément transposables à partir de ce qui est décrit ici.

Comme représenté sur la figure 1, une carte à puce 1 comporte un module 2. Le module 2 comprend un circuit flexible 3, muni d'un connecteur 5, et une puce 100. Le module 2 est généralement réalisé sous forme d'un élément séparé qui est inséré dans une cavité 4 ménagée dans la carte 1.

Le circuit flexible 3 comporte donc un connecteur 5 avec plusieurs contacts 15 auxquels est connectée la puce 100. Le circuit flexible 3 est représenté (en haut) vu par sa face avant 6 (face contact). Il est aussi représenté (en bas) vu par sa face arrière 7. Le circuit flexible 3 ainsi représenté correspond à un circuit flexible simple face pour carte « à contact ». Mais il pourrait tout aussi bien s'agir d'un circuit flexible double face, pour carte « dual » par exemple.

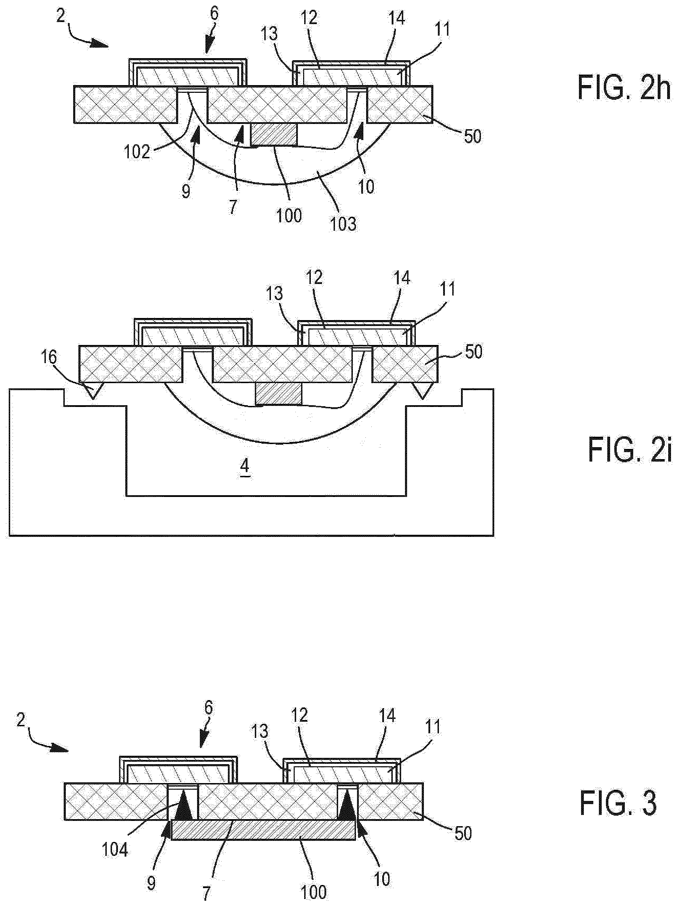

Les figures 2a à 2i illustrent schématiquement différentes étapes d'un exemple de procédé selon l'invention pour la fabrication du circuit flexible 3.

Ce procédé comprend la fourniture (Fig. 2a) d'un substrat 50 constitué d'un matériau diélectrique. Ce matériau diélectrique est constitué d'un pré-imprégné. Ce pré-imprégné est formé d'une résine époxy imprégnant un matériau fibreux. Ce matériau fibreux est par exemple un tissu de fibres de verre tissées. Ce tissu de fibres de verre est par exemple de type 1080 selon le code IPC, mais il peut être plus épais.

L'épaisseur du substrat 50 est supérieure à 50µm et de préférence supérieure à 75µm. Par exemple, cette épaisseur est comprise entre 90 et 120µm.

Le pré-imprégné constitutif du substrat 50 est de type « faible fluage » (« low-flow » selon la terminologie anglo-saxonne). Son fluage mesuré selon le standard IPC-TM-650 2.3.17.2 est inférieur ou égal à 0,7mm. Des pré-imprégnés ce de type sont commercialisés par exemple par les sociétés Doosan®, Rogers®, Isola®, TUC®, Elite Materials® ou ITEQ®.

Le substrat 50 est ensuite perforé pour former des puits de connexion 9, 10 (Fig. 2b) dont le diamètre est compris entre 300µm et 1000µm par exemple. En variante (non-représentée), en plus des puits de connexion 9, 10, le substrat peut également être perforé pour former une réserve dans laquelle une puce 100 pourra être ultérieurement logée. Afin d'éviter de générer, en particulier lors de la lamination de la feuille de matériau électriquement conducteur 11, des défauts (par exemple des surépaisseurs liées à des particules déposées sur le substrat 50) consécutivement à cette étape de perforation, on utilise un matériau pré-imprégné de qualité « sans poussière » (« dust-free » selon la terminologie anglo-saxonne). Cette qualité permet également une meilleure qualité de perforation sans endommagement de la matière autour des perforations (voir ci-dessous) qui pourrait générer des défauts lors des étapes ultérieures de photolithographie, de gravure ou de dépôts électrolytiques (par pénétration des bains entre la résine et les fibres par exemple).

A l'étape suivante, le substrat 50 est laminé avec une feuille de matériau électriquement conducteur 11. Cette feuille de matériau conducteur 11 est par exemple une feuille de cuivre (mais elle peut aussi être constituée d'une tôle d'acier ou d'aluminium ou d'un alliage de l'un de ces métaux : Cuivre, acier, aluminium). Elle a par exemple une épaisseur de l'ordre de 18 µm ou de 35 µm. Cette étape de lamination est menée à une température supérieure à la température de réactivation du pré-imprégné. Au-delà de cette température de réactivation, le pré-imprégné devient collant. La température de réactivation du pré-imprégné est par exemple comprise entre 100 et 150°C.

La pression utilisée pour laminer la feuille de matériau conducteur 11 sur le substrat 50 est par exemple comprise entre 2 et 6 bars.

Après cette étape, le pré-imprégné est réticulé pour figer sa structure, à une température comprise dans une plage de température de réticulation qui dépend de la nature de résine. Elle est par exemple de 180°C. Après réticulation, le pré-imprégné est suffisamment stable pour subir, sans dégradation notable, les étapes suivantes.

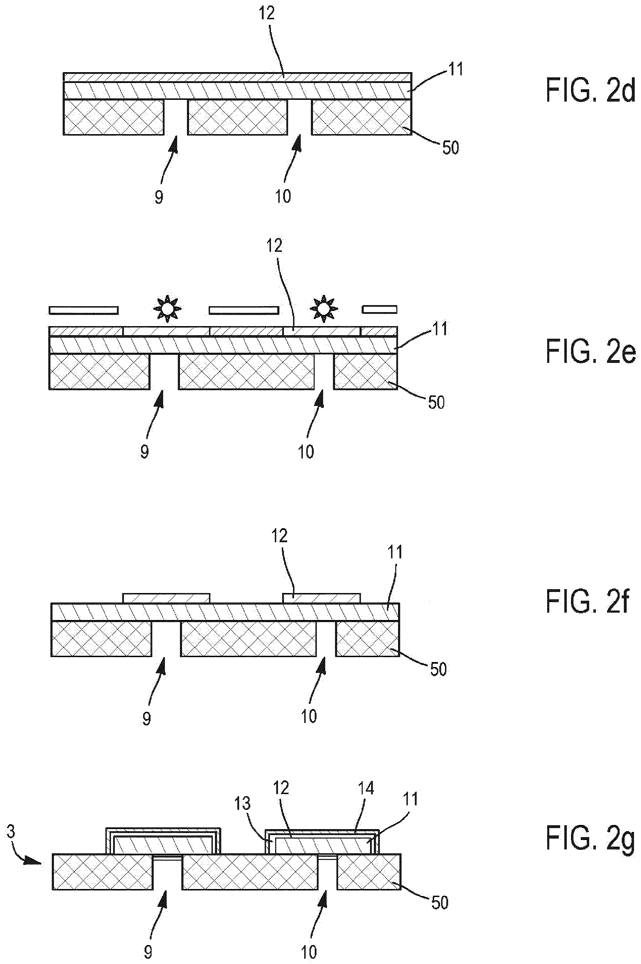

Un film sec de résine photosensible 12 (« photoresist » selon la terminologie anglo-saxonne) est ensuite laminé sur la face libre de la feuille de matériau conducteur 11 (Fig. 2d). Puis, ce film de résine photosensible 12 est insolé à travers un masque afin de définir des motifs pour un circuit électrique (Fig. 2e) et former un circuit imprimé flexible. Le film de résine photosensible 12 non insolé (Fig. 2f) est développé chimiquement, avant de graver chimiquement la couche conductrice 11 dans les zones non protégées par le film de résine photosensible 12. Les zones du film de résine photosensible 12 insolées sont ensuite dissoutes (« strippage » selon la terminologie anglo-saxonne), et des pistes et contacts obtenus après gravure de la couche conductrice 11 sont métallisés par galvano-chimie en une ou plusieurs étapes pour former, par exemple, une couche de nickel 13 et une couche d'or ou de palladium 14 ou d'argent (Fig. 2g).

Certaines étapes du procédé décrit ci-dessus sont spécifiques à la réalisation de modules 2 pour cartes à puce, mais des étapes telles que celle de la lamination du substrat 50 avec la feuille de matériau électriquement conducteur 11, ainsi que les étapes de gravures ou de métallisation subséquentes, peuvent bien entendu être utilisées pour d'autres applications.

Le circuit flexible 3 ainsi réalisé peut être utilisé pour connecter une puce 100 à des contacts 15 et réaliser un module électronique 2 selon différentes technologies d'assemblage microélectronique.

Ainsi, la figure 2h représente schématiquement le résultat d'étapes au cours desquelles une puce 100 est collée sur le substrat 50 par exemple à l'aide d'un adhésif. La puce 100 est collée sur la face arrière 7 et est reliée à la face avant 6 du circuit flexible par des fils 102 de connections en or de diamètre 25 µm, le tout étant ensuite protégé par une résine d'encapsulation 103.

Alternativement, comme représenté sur la figure 3, la technologie de la « puce retournée » (« flip-chip » selon la terminologie anglo-saxonne) permet de coller la puce 100, sur la face arrière 7 du substrat 50. La puce 100 est alors reliée à la face avant 6 du circuit flexible par des protubérances conductrices 104 (« bumps » selon la technologie anglo-saxonne) situées sous la puce 100. Le module 2 comporte donc une puce 100 connectée électriquement directement aux contacts 15 grâce à des protubérances conductrices 104 logées dans les puits de connexions 9. La puce 100 est éventuellement aussi encapsulée.

Un module électronique 2, tel que ceux illustrés par les figures 2h et 3 est ensuite encarté dans une cavité 4. La fixation du module 2 dans la cavité 4 peut être réalisée avec un adhésif réactivable à chaud 16 (« hotmelt » selon la terminologie anglo-saxonne).

Il est bien entendu possible de réaliser une structure double-face en laminant à chaud, en même temps, avant ou après l'étape correspondant à la figure 2c, une deuxième feuille de matériau conducteur (en cuivre ou un autre alliage), sur le substrat 50. Par exemple, une première feuille de matériau conducteur est laminée sur le pré-imprégné, avant l'étape illustrée par la figure 2a. Puis, le complexe comprenant le pré-imprégné et cette première feuille de matériau conducteur est perforée comme à l'étape illustrée par la figure 2b. Ensuite, le complexe ainsi perforé reçoit une deuxième feuille de matériau conducteur qui est laminée sur la face du pré-imprégné n'ayant pas déjà reçu la première feuille de matériau conducteur. Pour la lamination des première et deuxième feuilles de matériau conducteur, les propriétés d'adhésion réactivables à chaud du matériau pré-imprégné sont utilisées pour les fixer sur le substrat 50. On notera toutefois que dans le cas d'un substrat à double face (c'est-à-dire avec une feuille de matériau conducteur sur chaque face), le fluage peut être encore plus important, et donc pose un problème encore plus critique que dans le cas de la réalisation d'un substrat simple-face (c'est-à-dire avec une feuille de matériau conducteur sur une seule face), si la lamination de la deuxième feuille de matériau conducteur est effectuée à une plus haute température que la lamination de la première feuille de matériau conducteur. Après réticulation, des étapes de photolithographie et gravure analogues à celles décrites ci-dessus permettent ensuite de définir des circuits électriques (pistes conductrices, contacts, plots de connexion, antenne, etc.) sur chacune des deux faces.

Il est aussi possible, alternativement de laminer et de coller directement, grâce aux propriétés adhésives réactivables thermiquement d'un substrat 50 de matériau pré-imprégné, sur l'une, sur l'autre ou sur ses deux faces, des circuits prédécoupés dans une feuille de matériau conducteur (technologie dite du « leadframe » selon la terminologie anglo-saxonne), à la place de la technologie par photolithographie et gravure décrite ci-dessus.

Dans tous les cas mentionnés ci-dessus, il est nécessaire d'effectuer un traitement thermique approprié après l'étape de lamination, afin de réticuler le matériau pré-imprégné. Par exemple, l'étape de réticulation est réalisée à 180°C pendant quelques heures (par exemple un plateau d'une ou deux heures et des rampes de montée et descente en température).

Si cela est nécessaire pour l'agencement et les fonctionnalités du circuit obtenu par le procédé décrit ci-dessus, ou ses variantes, il est possible de métalliser au moins certains des puits de connexion 9, 10, à travers le substrat 50. En effet, avec des matériaux pré-imprégnés de qualité « sans poussière » comme indiqué ci-dessus, il est possible d'obtenir des bords des découpes perforées nets, sans fibres dépassant de plus de 100 µm, par exemple, à l'intérieur des perforations servant à la soudure des fils de connexion 102.

L'un des avantages du procédé décrit ci-dessus et de ses variantes, réside dans le fait qu'ils peuvent être mis en oeuvre de façon continue en utilisant des bobines sur lesquelles sont enroulées les bandes de matériau conducteur ou diélectrique. Les valeurs des paramètres de tenue en traction du matériau pré-imprégné peuvent être dans ce cas critiques. Par exemple ces paramètres ont les valeurs suivantes :
- Module d'Young en longitudinal (dans le sens de défilement d'une bobine à l'autre) supérieur ou égal à 3GigaPa,
- Elongation à la rupture supérieure ou égale à 1% (avec un maximum par exemple à 10%) et
- Résistance à la rupture supérieure ou égale à 50 MPa

## Revendications

1. Procédé de fabrication d'un circuit imprimé flexible (3), comprenant :
- la fourniture d'une feuille de matériau électriquement conducteur (11), ayant une première et une deuxième face,
- la fourniture d'une couche de matériau diélectrique (50) ayant une première et une deuxième face,
- la perforation d'au moins un puits de connexion à travers la couche de matériau diélectrique,
- la lamination, après la perforation d'au moins un puits de connexion, de la feuille de matériau électriquement conducteur (11) avec la couche de matériau diélectrique (50), la feuille de matériau électriquement conducteur (11) formant une surface de connexion au fond d'au moins un puits de connexion, dans lequel
- la couche de matériau diélectrique est constituée d'un matériau pré-imprégné, ce pré-imprégné étant constitué d'une résine imprégnant un renfort,
- l'étape de perforation d'au moins un puits de connexion est réalisée avant la lamination de la couche de matériau diélectrique (50) avec la première face de la feuille de matériau électriquement conducteur (11),
- l'étape de lamination de la feuille de matériau électriquement conducteur (11) avec la couche de matériau diélectrique (50), est réalisée alors que la première face de la couche de matériau diélectrique (50) est directement mise en contact avec la première face de la feuille de matériau électriquement conducteur (11),
- et **caractérisé par le fait que** le pré-imprégné a un fluage inférieur ou égal à 0,7mm mesuré selon le standard IPC-TM-650 2.3.17.2.

2. Procédé selon la revendication 1, dans lequel l'étape de lamination de la feuille de matériau électriquement conducteur (11) avec la couche de matériau diélectrique (50), est réalisée en continu à une température comprise entre 80 et 200°C et sous une pression comprise entre 2 et 6 bars.

3. Procédé selon l'une des revendications précédentes dans lequel une étape de réticulation de la résine est réalisée après l'étape de lamination de la feuille de matériau électriquement conducteur (11) avec la couche de matériau diélectrique (50).

4. Procédé selon l'une des revendications précédentes, dans lequel la résine est choisie dans la liste comprenant les résines époxy et les résines de polyesters insaturés.

5. Procédé selon l'une des revendications précédentes, dans lequel le renfort est choisi parmi un textile de fibres tissées, un textile de fibres non-tissées, des fibres de verre, des fibres de polyester, des fibres de carbone et des fibres de polyaramide.

6. Procédé selon l'une des revendications précédentes, dans lequel le pré-imprégné est de qualité dite « sans poussière ».

7. Procédé selon l'une des revendications précédentes, dans lequel l'étape de perforation d'au moins un puits de connexion est réalisée après lamination d'une première feuille de matériau électriquement conducteur sur la première face de la couche de matériau diélectrique (50) et dans lequel une deuxième feuille de matériau électriquement conducteur est laminée sur la deuxième face de la couche de matériau diélectrique (50).

8. Circuit imprimé flexible (3) comprenant :
- une couche de matériau diélectrique (50) ayant une première et une deuxième face,
- une feuille de matériau électriquement conducteur (11), ayant une première et une deuxième face, recouvrant au moins partiellement la couche de matériau diélectrique (50),
- au moins un puits de connexion à travers la couche de matériau diélectrique, la feuille de matériau électriquement conducteur (11) formant une surface de connexion au fond d'au moins un puits de connexion, dans lequel la couche de matériau diélectrique est constituée d'un matériau pré-imprégné, ce pré-imprégné étant constitué d'une résine imprégnant un renfort, la première face de la couche de matériau diélectrique (50) est directement au contact de la première face de la feuille de matériau électriquement conducteur (11), et **caractérisé par le fait que** le pré-imprégné a un fluage inférieur ou égal à 0,7mm mesuré selon le standard IPC-TM-650 2.3.17.2.

9. Circuit imprimé flexible selon la revendication 8, dans lequel la résine est choisie dans la liste comprenant les résines époxy et les résines de polyesters insaturés.

10. Circuit imprimé flexible selon la revendication 8 ou 9, dans lequel le renfort est choisi parmi un textile de fibres tissées, un textile de fibres non-tissées, des fibres de verre, des fibres de polyester, des fibres de carbone et des fibres de polyaramide.

11. Carte à puce comportant un corps de carte (1) et une cavité (4) ménagée dans le corps de carte et dans laquelle est placé un module électronique (2) comportant un circuit flexible (3) selon l'une des revendications 8 à 10, le circuit flexible (3) comportant une zone fixée au corps de carte (1).

## Patentansprüche

1. Verfahren zur Herstellung einer flexiblen Leiterplatte (3), umfassend:
- die Bereitstellung einer Folie aus elektrisch leitendem Material (11) mit einer ersten und einer zweiten Seite,
- die Bereitstellung einer Schicht aus dielektrischem Material (50) mit einer ersten und einer zweiten Seite,
- das Stanzen von mindestens einem Anschlussloch durch die Schicht aus dielektrischem Material hindurch,
- das Laminieren, nach dem Stanzen von mindestens einem Anschlussloch, der Folie aus elektrisch leitendem Material (11) mit der Schicht aus dielektrischem Material (50), wobei die Folie aus elektrisch leitendem Material (11) eine Anschlussfläche am Boden mindestens eines Anschlusslochs bildet,
wobei
- die Schicht aus dielektrischem Material aus einem vorimprägnierten Material besteht, wobei dieses Prepreg aus einem eine Verstärkung imprägnierenden Harz besteht,
- der Schritt des Stanzens von mindestens einem Anschlussloch vor dem Laminieren der Schicht aus dielektrischem Material (50) mit der ersten Seite der Folie aus elektrisch leitendem Material (11) ausgeführt wird,
- der Schritt des Laminierens der Folie aus elektrisch leitendem Material (11) mit der Schicht aus dielektrischem Material (50) ausgeführt wird, während die erste Seite der Schicht aus dielektrischem Material (50) direkt mit der ersten Seite der Folie aus elektrisch leitendem Material (11) in Kontakt gebracht wird,
**dadurch gekennzeichnet, dass** das Prepreg ein Fließen von kleiner als oder gleich 0,7 mm, gemessen nach dem Standard IPC-TM-650 2.3.17.2, aufweist.

2. Verfahren nach Anspruch 1, wobei der Schritt des Laminierens der Folie aus elektrisch leitendem Material (11) mit der Schicht aus dielektrischem Material (50) kontinuierlich bei einer Temperatur zwischen 80 und 200°C und unter einem Druck zwischen 2 und 6 bar ausgeführt wird.

3. Verfahren nach einem der vorhergehenden Ansprüche, wobei ein Schritt des Vernetzens des Harzes nach dem Schritt des Laminierens der Folie aus elektrisch leitendem Material (11) mit der Schicht aus dielektrischem Material (50) ausgeführt wird.

4. Verfahren nach einem der vorhergehenden Ansprüche, wobei das Harz aus der Liste gewählt wird, die Epoxidharze und ungesättigte Polyesterharze umfasst.

5. Verfahren nach einem der vorhergehenden Ansprüche, wobei die Verstärkung unter einem Webstoff, einem Vliesstoff, Glasfasern, Polyesterfasern, Carbonfasern und Polyaramidfasern gewählt wird.

6. Verfahren nach einem der vorhergehenden Ansprüche, wobei das Prepreg eine sogenannte "staubfreie" Beschaffenheit aufweist.

7. Verfahren nach einem der vorhergehenden Ansprüche, wobei der Schritt des Stanzens von mindestens einem Anschlussloch nach dem Laminieren einer ersten Folie aus elektrisch leitendem Material auf die erste Seite der Schicht aus dielektrischem Material (50) ausgeführt wird und wobei eine zweite Folie aus elektrisch leitendem Material auf die zweite Seite der Schicht aus dielektrischem Material (50) laminiert wird.

8. Flexible Leiterplatte (3), umfassend:
- eine Schicht aus dielektrischem Material (50) mit einer ersten und einer zweiten Seite,
- eine Folie aus elektrisch leitendem Material (11) mit einer ersten und einer zweiten Seite, die zumindest teilweise die Schicht aus dielektrischem Material (50) überdeckt,
- mindestens ein Anschlussloch durch die Schicht aus dielektrischem Material hindurch, wobei die Folie aus elektrisch leitendem Material (11) eine Anschlussfläche am Boden mindestens eines Anschlusslochs bildet,
wobei die Schicht aus dielektrischem Material aus einem vorimprägnierten Material besteht, wobei dieses Prepreg aus einem eine Verstärkung imprägnierenden Harz besteht und die erste Seite der Schicht aus dielektrischem Material (50) direkt in Kontakt mit der ersten Seite der Folie aus elektrisch leitendem Material (11) steht, **dadurch gekennzeichnet, dass** das Prepreg ein Fließen von kleiner als oder gleich 0,7 mm, gemessen nach dem Standard IPC-TM-650 2.3.17.2, aufweist.

9. Flexible Leiterplatte nach Anspruch 8, wobei das Harz aus der Liste gewählt wird, die Expoxidharze und ungesättigte Polyesterharze umfasst.

10. Flexible Leiterplatte nach Anspruch 8 oder 9, wobei die Verstärkung unter einem Webstoff, einem Vliesstoff, Glasfasern, Polyesterfasern, Carbonfasern und Polyaramidfasern gewählt wird.

11. Chipkarte mit einem Kartenkörper (1) und einer Kavität (4), die in dem Kartenkörper ausgebildet ist und in die ein elektronisches Modul (2) gesetzt wird, das eine flexible Leiterplatte (3) nach einem der Ansprüche 8 bis 10 umfasst, wobei die Leiterplatte (3) einen am Kartenkörper (1) befestigten Bereich umfasst.

## Claims

1. Method for fabricating a flexible printed circuit (3), comprising:
- the provision of a sheet of electrically conductive material (11), having a first and a second face;
- the provision of a layer of dielectric material (50) having a first and a second face;
- the perforation of at least one bonding hole through the layer of dielectric material;
- the lamination, after the perforation of at least one bonding hole, of the sheet of electrically conductive material (11) with the layer of dielectric material (50), the sheet of electrically conductive material (11) forming a connection area at the bottom of at least one bonding hole,
in which
the layer of dielectric material consists of a pre-impregnated material, this prepreg consisting of a resin impregnating a reinforcement;
the step of perforating at least one bonding hole is carried out before the lamination of the layer of dielectric material (50) with the first face of the sheet of electrically conductive material (11);
the step of laminating the sheet of electrically conductive material (11) with the layer of dielectric material (50) is carried out while the first face of the layer of dielectric material (50) is placed in direct contact with the first face of the sheet of electrically conductive material (11),
and **characterized by** the fact that the flow of the prepreg is less than or equal to 0.7 mm measured according to standard IPC-TM-650 2.3.17.2.

2. Method according to Claim 1, in which the step of laminating the sheet of electrically conductive material (11) with the layer of dielectric material (50) is carried out continuously at a temperature of between 80 and 200°C and under a pressure of between 2 and 6 bars.

3. Method according to either of the preceding claims, in which a step of crosslinking the resin is carried out after the step of laminating the sheet of electrically conductive material (11) with the layer of dielectric material (50).

4. Method according to one of the preceding claims, in which the resin is chosen from the list comprising epoxy resins and unsaturated polyester resins.

5. Method according to one of the preceding claims, in which the reinforcement is chosen from a woven fibre textile, a nonwoven fibre textile, glass fibres, polyester fibres, carbon fibres and polyaramide fibres.

6. Method according to one of the preceding claims, in which the prepreg is of "dust-free" quality.

7. Method according to one of the preceding claims, in which the step of perforating at least one bonding hole is carried out after lamination of a first sheet of electrically conductive material on the first face of the layer of dielectric material (50) and in which a second sheet of electrically conductive material is laminated on the second face of the layer of dielectric material (50).

8. Flexible printed circuit (3), comprising:
- a layer of dielectric material (50) having a first and a second face;
- a sheet of electrically conductive material (11), having a first and a second face, at least partially covering the layer of dielectric material (50);
- at least one bonding hole through the layer of dielectric material, the sheet of electrically conductive material (11) forming a connection area at the bottom of at least one bonding hole, in which the layer of dielectric material consists of a pre-impregnated material, this prepreg consisting of a resin impregnating a reinforcement, and the first face of the layer of dielectric material (50) makes direct contact with the first face of the sheet of electrically conductive material (11), and **characterized by** the fact that the flow of the prepreg is less than or equal to 0.7 mm measured according to standard IPC-TM-650 2.3.17.2.

9. Flexible printed circuit according to Claim 8, in which the resin is chosen from the list comprising epoxy resins and unsaturated polyester resins.

10. Flexible printed circuit according to Claim 8 or 9, in which the reinforcement is chosen from a woven fibre textile, a nonwoven fibre textile, glass fibres, polyester fibres, carbon fibres and polyaramide fibres.

11. Chip card including a card body (1) and a cavity (4) made in the card body and in which cavity is placed an electronic module (2) including a flexible circuit (3) according to one of Claims 8 to 10, the flexible circuit (3) including a zone fixed to the card body (1).
